# EUROPEAN PATENT APPLICATION

(11) **EP 4 610 045 A1**
(43) Date of publication of application: **03.09.2025**
(21) Application number: 23882569.9
(22) Date of filing: 23.10.2023
(51) Int. Cl.: B32B 7/027, B32B 15/08, B32B 27/18, H05K 1/03, H05K 1/05

(54) **MULTILAYER BODY AND METHOD FOR PRODUCING SAME**

(30) Priority: 28.10.2022 JP 2022172962
(71) Applicant: Teijin Limited, Osaka-shi, Osaka 530-0005 (JP)
(72) Inventor: SOEDA, Junshi, Osaka-shi, Osaka 530-0005 (JP); MAEDA, Masanori, Osaka-shi, Osaka 530-0005 (JP); YAMANAKA, Katsuhiro, Osaka-shi, Osaka 530-0005 (JP)
(74) Representative: Carpmaels & Ransford LLP
(86) International application number: PCT/JP2023/038120
(87) International publication number: WO 2024/090364

(57) **Abstract**

There is provided a laminate which is excellent in heat dissipation in a thickness direction, thermal diffusivity in an in-plane direction, and insulation in the thickness direction, and that is not easily cracked. The laminate includes: a metal layer A; an insulating layer provided on at least one surface of the metal layer A, and a metal layer B provided on a surface of the insulating layer opposite to the metal layer A. The insulating layer includes a support layer and a heat transfer layer containing at least an inorganic filler and a binder resin. The support layer and the heat transfer layer are alternately laminated in a total of three or more layers in a direction substantially perpendicular to a thickness direction of the insulating layer.

## Description

### Technical Field

The present invention relates to a laminate excellent in heat dissipation, particularly in heat dissipation in a thickness direction, and a method for producing the same.

### Background Art

In recent years, miniaturization of electronic components has been required, high-density packaging and high performance have been required, and further, due to miniaturization and high power of semiconductor elements and the like, how to dissipate heat generated from the semiconductor elements and the like in a narrow space has become a problem.

As one of solutions to the above problem, a method is used in which a ceramic plate material having a high thermal conductivity is used for an insulating layer of a substrate on which a component is mounted, and heat generated in an element is efficiently dissipated to a housing or a cooling fin. However, a ceramic plate processed to be thin in order to reduce thermal resistance in a thickness direction may be easily cracked.

In order to improve the ease of cracking of a substrate material, a resin material having an increased thermal conductivity is used as an insulating layer instead of a ceramic plate (see Patent Literatures 1 and 2). In Patent Literature 1, a high thermal conductivity is studied by filling a resin with an alumina powder. However, in Patent Literature 1, since the alumina powder is used, high filling exceeding 80 vol% is possible, but the thermal conductivity of the substrate may be low since a thermal conductivity of the alumina powder itself is low.

In Patent Literature 2, a boron nitride powder is used and an orientation thereof is controlled to achieve a high thermal conductivity with a low filler filling amount. Primary particles of the boron nitride powder are generally flaky, and when the boron nitride powder is dispersed as a filler in the insulating layer, the boron nitride powder is aligned in a plane direction during coating or press curing, and a high thermal conductivity cannot be expected. However, by dispersing boron nitride powder aggregates within the insulating layer, the orientation thereof is controlled in a vertical direction, a high thermal conductivity can be achieved and a thermal path can be efficiently formed, which allows a filling amount to be reduced, and as a result, a withstand voltage value is improved. However, in Patent Literature 2, the aggregated powder to be used must have high particle strength and the agglomerated powder must have few voids such that it does not break down during a substrate production process. Therefore, there is a problem that deformation does not occur due to the high particle strength, it is difficult to fill the resin into the voids in the inside, electrical characteristics such as an electrical insulation property are deteriorated, a contact between the boron nitride powders is not sufficiently obtained, and the effect of improving the thermal conductivity is reduced.

In Patent Literature 3 and Patent Literature 4, A sheet of thermoplastic fluorine resin with carbon nanotubes dispersed is rolled and molded, the obtained sheet is laminated and then hot-pressed to obtain a resin block, and the resin block is further sliced to obtain a resin sheet in which the carbon nanotubes as a filler are oriented in a thickness direction. Since the carbon nanotubes are oriented in the thickness direction, a resin sheet having an excellent thermal conductivity in the thickness direction can be obtained. However, since the resin sheets disclosed in Patent Literature 3 and Patent Literature 4 contain a conductive material such as carbon nanotubes as a filler, the obtained resin sheet is conductive and cannot be applied to a circuit board required to have insulation properties.

### Citation List

### Patent Literature

Patent Literature 1: JPH06-44824A
Patent Literature 2: JP2010-157563A
Patent Literature 3: JP7092299B
Patent Literature 4: JP2021-4284A

### Summary of Invention

### Technical Problem

An object of the invention is to provide a laminate that is excellent in heat dissipation in a thickness direction, thermal diffusivity in an in-plane direction, and insulation in the thickness direction, and that is not easily cracked, and a method for producing the laminate. Another object of the invention is to provide a circuit board using the laminate.

### Solution to Problem

The present inventors have found that the above problems are solved by the following aspects:
<Aspect 1> A laminate including:
   a metal layer A;
   an insulating layer provided on at least one surface of the metal layer A; and
   a metal layer B provided on a surface of the insulating layer opposite to the metal layer A, in which
   the insulating layer includes a support layer and a heat transfer layer containing at least an inorganic filler and a binder resin, and
   the support layer and the heat transfer layer are alternately laminated in a total of three or more layers in a direction substantially perpendicular to a thickness direction of the insulating layer.
<Aspect 2> The laminate according to Aspect 1, in which
   the inorganic filler has a plate shape, and the inorganic filler is substantially perpendicular to an in-plane direction of the laminate.
<Aspect 3> The laminate according to Aspect 1 or 2, in which
   the inorganic filler contains a hexagonal boron nitride particle.
<Aspect 4> The laminate according to any of Aspects 1 to 3, in which
   the binder resin is an aramid resin.
<Aspect 5> The laminate according to any of Aspects 1 to 4, in which
   tensile shear adhesive strength between the insulating layer and the metal layer is 0.1 MPa or more.
<Aspect 6> The laminate according to any of Aspects 1 to 5, in which
   the support layer has a modulus of 10 MPa or more.
<Aspect 7> A circuit board comprising:
   the laminate according to any of Aspects 1 to 6.
<Aspect 8> A method for producing a laminate, which is a method for producing the laminate according to any one of Aspects 1 to 6, the method including:
   a step of preparing a heat transfer layer using a slurry containing a plate-shaped inorganic filler, a binder resin, and a solvent;
   a step of preparing an insulating layer by alternately laminating the heat transfer layer and a support layer and then performing cutting; and
   a step of forming a metal layer by bonding metal layers to respective surfaces of the insulating layer.

### Advantageous Effects of Invention

According to the invention, a laminate that is excellent in heat dissipation in a thickness direction, thermal diffusivity in an in-plane direction, and insulation in the thickness direction, and that is not easily cracked can be provided. According to the invention, a method for producing such a laminate can be provided. The laminate of the invention can be suitably used as a circuit board which requires insulation and heat dissipation particularly in a thickness direction.

### Brief Description of Drawings

[FIG. 1] FIG. 1 illustrates a schematic diagram of a cross section of a laminate according to an embodiment of the present disclosure.
[FIG. 2] FIG. 2 illustrates a scanning electron microscope photograph of a cross section of a laminate according to an Example that is perpendicular to a plane direction.
[FIG. 3] FIG. 3 illustrates a scanning electron microscope photograph of a cross section of a laminate according to Comparative Example 2 that is perpendicular to a plane direction.

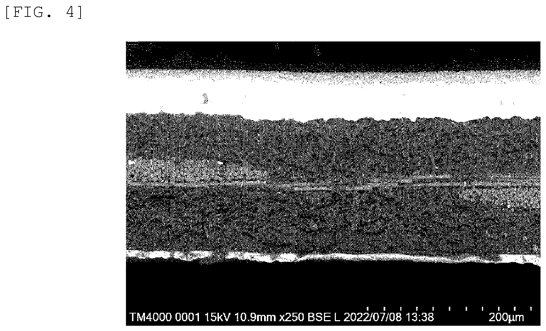

[FIG. 4] FIG. 4 illustrates a scanning electron microscope photograph of a cross section of a laminate according to Comparative Example 3 that is perpendicular to a plane direction.

### Description of Embodiments

Hereinafter, embodiments of the invention will be described.

### <<Laminate>>

A laminate of the present disclosure includes a metal layer A, an insulating layer provided on at least one surface of the metal layer A, and a metal layer B provided on a surface of the insulating layer opposite to the metal layer A. The insulating layer has at least a structure in which a support layer and a heat transfer layer are alternately laminated in a total of three or more layers. The heat transfer layer contains at least a plate-shaped inorganic filler. The inorganic filler is oriented in a direction substantially perpendicular to the insulating layer.

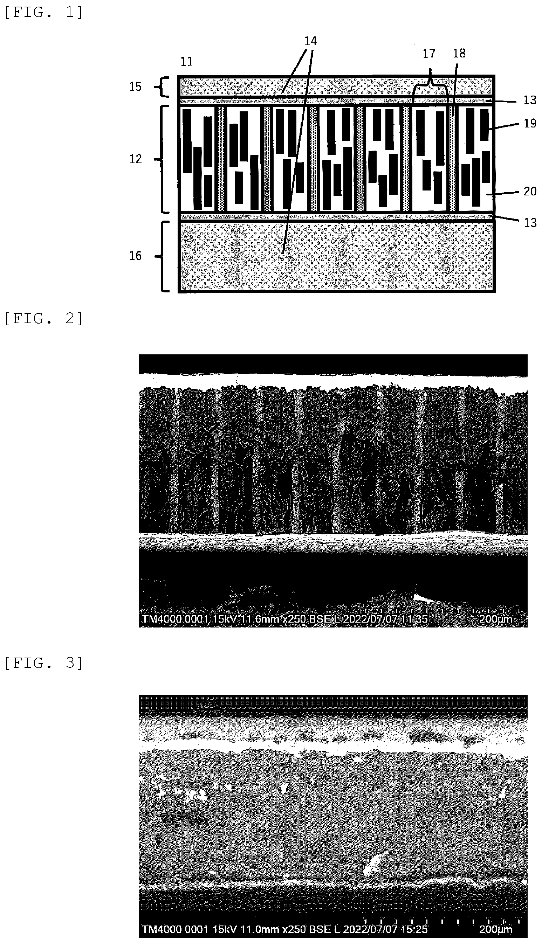

FIG. 1 illustrates a schematic diagram of a cross section of a laminate according to one embodiment of the present disclosure that is perpendicular to a plane direction. As illustrated in FIG. 1, a laminate 11 has a configuration in which the metal layer A is provided on one surface of a planar insulating layer 12 and the metal layer B is provided on the other surface of the planar insulating layer 12. Adhesive layers 13 may be provided between the insulating layer and the metal layer A and between the insulating layer and the metal layer B.

### <Thickness>

A thickness of the laminate may vary depending on a thermal resistance value and a dielectric breakdown voltage required for the laminate, and is, for example, 0.05 mm to 20 mm, and preferably 0.1 mm to 10 mm.

### <Thermal Resistance Value in Thickness Direction>

Preferably, the laminate according to the present disclosure has a thermal resistance value of 0.60 (K•cm²)/W or less in a thickness direction.

In particular, when copper plates having a thickness of 1 mm are used on both surfaces, the thermal resistance value of the laminate in the thickness direction may be 0.60 (K•cm²)/W or less, 0.57 (K•cm²)/W or less, 0.54 (K•cm²)/W or less, 0.51 (K•cm²)/W or less, 0.48 (K•cm²)/W or less, 0.45 (K•cm²)/W or less, 0.42 (K•cm²)/W or less, 0.39 (K•cm²)/W or less, 0.36 (K•cm²)/W or less, 0.33 (K•cm²)/W or less, 0.30 (K•cm²)/W or less, or 0.26 (K•cm²)/W or less, and/or 0.06 (K•cm²)/W or more, 0.09 (K•cm²)/W or more, 0.12 (K•cm²)/W or more, or 0.15 (K•cm²)/W or more. When the laminate of the invention is applied to a circuit board, the thermal resistance value is preferably 0.39 (K•cm²)/W or less, more preferably 0.36 (K•cm²)/W or less, still more preferably 0.33 (K•cm²)/W or less, and particularly preferably 0.30 (K•cm²)/W or less, from the viewpoint of imparting good heat dissipation to the laminate.

The thermal resistance value of the laminate can be determined by a steady-state method.

### <Dielectric Breakdown Voltage>

Preferably, the dielectric breakdown voltage of the laminate in the thickness direction is 3 kV/mm or more, 4 kV/mm or more, 5 kV/mm or more, 6 kV/mm or more, 7 kV/mm or more, or 8 kV/mm or more. It is preferable that the dielectric breakdown voltage is 5 kV/mm or more, since dielectric breakdown is less likely to occur, and defects of electronic devices can be avoided.

The dielectric breakdown voltage of the laminate can be measured in accordance with the test standard ASTM D149-20. For the measurement, a dielectric strength test device can be used.

Hereinafter, each element forming the laminate of the present disclosure will be described in more detail.

### <<Insulating Layer>>

In the insulating layer according to the present disclosure, a heat transfer layer having a high thermal conductivity in an in-plane direction and a support layer that bonds the heat transfer layer together to maintain the structure are used. In the insulating layer according to the present disclosure, a lamination direction of such a heat transfer layer is substantially perpendicular to a thickness direction of the insulating layer, whereby a thermal conductivity of the insulating layer in the thickness direction is relatively high, and the thermal resistance value of the laminate in the thickness direction is relatively low.

Here, in the invention, the expression "the lamination direction is substantially perpendicular to the thickness direction of the insulating layer" means that an angle between the lamination direction and the thickness direction is 45° to 135°, and the angle is preferably 55° to 125°, 65° to 115°, 75° to 105°, 85° to 95°, 87° to 93°, or 89° to 91°.

In the insulating layer according to the present disclosure, it is preferable that the heat transfer layer is continuously present between one main surface and the other main surface of the insulating layer and is present in a manner that is exposed to both the one main surface and the other main surface. With this configuration, heat can be dissipated from the member and metal layer in contact with one surface of the insulating layer to the member and metal layer in contact with the other surface of the insulating layer.

In the insulating layer according to the present disclosure, when the support layer is present, it is preferable that the support layer is present continuously or discontinuously between the one main surface and the other main surface of the insulating layer, and is present in a manner that is exposed on the one main surface and the other main surface. When the support layer is present in this manner, in particular, the adhesive layer and the support layer are firmly adhered to each other, strong adhesive strength between the insulating layer and the adhesive layer can be obtained, and preferred tensile shear adhesive strength between the insulating layer and the metal layer can be obtained.

In the insulating layer according to the present disclosure, the heat transfer layer forming the insulating layer occupies at least 50 vol% of the insulating layer. In this case, since a proportion of the heat transfer layer having a relatively high thermal conductivity in the thickness direction is increased, a laminate having a relatively low thermal resistance value in the thickness direction can be provided.

Preferably, the proportion of the heat transfer layer to the insulating layer may be 55 vol% or more, 60 vol% or more, 65 vol% or more, or 70 vol% or more, and/or 100 vol% or less, less than 100 vol%, less than 99 vol%, less than 98 vol%, less than 95 vol%, or less than 90 vol%.

A thickness of the heat transfer layer can be set freely, and the thickness of the heat transfer layer may be 0.1 µm or more, 1 µm or more, 10 µm or more, or 20 µm or more, and/or 1000 µm or less, 100 µm or less, 80 µm or less, 70 µm or less, or 60 µm or less.

As the thickness of the heat transfer layer increases with respect to the thickness of the support layer, the thermal resistance value of the obtained laminate in the thickness direction decreases. Therefore, the thickness of the heat transfer layer is preferably relatively large. For example, the thickness of the heat transfer layer in the lamination direction is preferably twice or more the thickness of the support layer in the lamination direction. In this case, a laminate having a relatively low thermal resistance value in a thickness direction can be provided.

As the thickness of the heat transfer layer is smaller than the thickness of the support layer, the tensile shear adhesive strength between the insulating layer and the metal layer of the laminate can be increased. Therefore, in order to increase the tensile shear adhesive strength between the insulating layer and the metal layer, the thickness of the support layer is preferably larger than the thickness of the heat transfer layer. For example, the thickness of the heat transfer layer in the lamination direction is preferably 100 times or less the thickness of the support layer in the lamination direction.

In order to increase the tensile shear adhesive strength between the insulating layer and the metal layer, preferably, the thickness of the heat transfer layer in the lamination direction is 0.8 times or more, 1 time or more, 1.2 times or more, 1.5 times or more, 2 times or more, 3 times or more, or 4 times or more, and/or 100 times or less, 80 times or less, 50 times or less, 40 times or less, 30 times or less, 20 times or less, 10 times or less, 8 times or less, 7 times or less, 6 times or less, or 5 times or less the thickness of the support layer in the lamination direction, preferably, the thickness of the heat transfer layer in the lamination direction is 1.5 times or more, 2 times or more, 3 times or more, or 4 times or more, and/or 50 times or less, 40 times or less, 30 times or less, 20 times or less, 10 times or less, 8 times or less, 7 times or less, 6 times or less, or 5 times or less the thickness of the support layer in the lamination direction, and more preferably, the thickness of the heat transfer layer in the lamination direction is 2 times or more or 3 times or more, and/or 30 times or less, 20 times or less, 10 times or less, 8 times or less, 7 times or less, 6 times or less, or 5 times or less the thickness of the support layer in the lamination direction.

It is preferable that the thickness of the heat transfer layer is within the above range, since the thermal conductivity of the insulating layer sufficient to obtain a low thermal resistance in the thickness direction of the laminate can be obtained, and at the same time, a proportion of a surface where the support layer is exposed, which greatly contributes to the adhesive force between the insulating layer and the adhesive layer, to the main surface of the insulating layer can be set to such a degree that strong adhesiveness between the insulating layer and the adhesive layer can be ensured, and thus, a low thermal resistance value of the laminate in the thickness direction can be obtained without reducing the tensile shear adhesive strength between the insulating layer and the metal layer.

A total number of heat transfer layers and support layers provided in the insulating layer can be set freely, and is, for example, 3 or more, preferably 11 or more, and more preferably 21 or more. An upper limit of the total number of heat transfer layers provided in the insulating layer is not particularly limited, and the total number may be, for example, 100000 layers or less, 50000 layers or less, 10000 layers or less, or 5000 layers or less.

### <Average Thermal Conductivity in In-plane Direction>

Preferably, the insulating layer according to the present disclosure has an average thermal conductivity of 15 W/(m•K) or more in the in-plane direction.

In particular, the average thermal conductivity of the insulating layer in the in-plane direction may be 17.5 W/ (m•K) or more, or 20 W/(m•K) or more, and/or 60 W/ (m•K) or less, 50 W/(m•K) or less, or 40 W/(m•K) or less.

The average thermal conductivity of the insulating layer in the in-plane direction can be calculated by adding a thermal conductivity in an any direction X along a plane of the insulating layer and a thermal conductivity in a direction Y perpendicular to the direction X along the plane of the insulating layer and dividing the sum by 2.

The thermal conductivity of the insulating layer in the in-plane direction can be calculated by multiplying thermal diffusivity in the in-plane direction, a specific gravity, and specific heat. That is, the thermal conductivity can be calculated based on (thermal conductivity in in-plane direction) = (thermal diffusivity in in-plane direction) × (specific heat) × (specific gravity).

The thermal diffusivity in the in-plane direction can be measured by a periodic heating radiation temperature measurement method. The specific heat can be determined by a differential scanning calorimeter. The specific gravity can be determined based on an outer dimension and a weight of the insulating layer.

### <Average Thermal Conductivity in Thickness Direction>

Preferably, the insulating layer according to the present disclosure has a thermal conductivity of 20 W/(m•K) or more in the thickness direction.

In particular, an average thermal conductivity of the insulating layer in the thickness direction may be 22.5 W/(m•K) or more, or 25 W/(m•K) or more, and/or 70 W/(m•K) or less, 60 W/(m•K) or less, or 50 W/(m•K) or less.

The thermal conductivity of the insulating layer in the thickness direction can be calculated by multiplying thermal diffusivity in the thickness direction, a specific gravity, and specific heat. That is, the thermal conductivity can be calculated based on (thermal conductivity in thickness direction) = (thermal diffusivity in in-plane direction) × (specific heat) × (specific gravity).

The thermal diffusivity in the thickness direction can be measured by a temperature wave analysis method. The specific heat can be determined by a differential scanning calorimeter. The specific gravity can be determined based on an outer dimension and a weight of the insulating layer.

### <Real Part (Relative Permittivity) of Complex Permittivity of Insulating Layer>

A preferred range of a real part (a relative permittivity) of a complex permittivity of the insulating layer according to the present disclosure is 15 or less, 12 or less, 10 or less, 9 or less, 8 or less, 7 or less, 6 or less, or 5 or less, and 1 or more, 2 or more, 3 or more, or 4 or more. The preferred range is more preferably 2 or more and 10 or less, and still more preferably 2 or more and 5 or less. When the real part (the relative permittivity) of the complex permittivity of the insulating layer is within the range, there is an advantage that stray capacitance of the laminate can be reduced. A frequency at which such a real part (a relative permittivity) of the complex permittivity is obtained can be selected freely depending on a required frequency, and can be, for example, 1 kHz and/or 1 MHz.

### <Dielectric Loss Tangent of Insulating Layer>

A preferred range of a dielectric loss tangent of the insulating layer according to the present disclosure is 1 or less, 0.5 or less, 0.3 or less, 0.2 or less, 0.1 or less, 0.09 or less, 0.08 or less, 0.07 or less, 0.06 or less, 0.05 or less, 0.04 or less, 0.03 or less, or 0.02 or less, and 0.005, 0.006 or more, 0.007 or more, 0.008 or more, 0.009 or more, or 0.01 or more. The preferred range is more preferably 0.006 or more and 0.5 or less, and still more preferably 0.008 or more and 0.3 or less. When the dielectric loss tangent of the insulating layer is within the range, for example, there is an advantage that a transmission loss of a circuit can be reduced in a case where the laminate is used as a circuit board. A frequency at which such a dielectric loss tangent is obtained can be selected freely depending on a required frequency, and can be, for example, 1 kHz and/or 1 MHz.

The dielectric loss tangent of the insulating layer according to the present disclosure can be obtained by dividing an imaginary part of the complex permittivity of the insulating layer by the real part (the relative permittivity) of the complex permittivity of the insulating layer.

### <<Heat Transfer Layer>>

The heat transfer layer according to the present disclosure contains at least a plate-shaped inorganic filler oriented in an in-plane direction of the heat transfer layer, and a binder resin.

### <Parts by Mass>

Preferably, the inorganic filler contained in the heat transfer layer according to the present disclosure may be 70 parts by mass or more, 80 parts by mass or more, or 90 parts by mass or more, and/or 99 parts by mass or less, 97 parts by mass or less, 95 parts by mass or less, or 93 parts by mass or less, with respect to 100 parts by mass of the heat transfer layer.

Preferably, the binder resin contained in the heat transfer layer according to the present disclosure may be 1 part by mass or more, 3 parts by mass or more, 5 parts by mass or more, or 7 parts by mass or more, and/or 30 parts by mass or less, 20 parts by mass or less, or 10 parts by mass or less, with respect to 100 parts by mass of the heat transfer layer.

### <Inorganic Filler>

The inorganic filler is any particle that is insulating and has a thermal conductivity higher than that of the binder resin. The inorganic filler is not particularly limited, and examples thereof include particles of silica, talc, mica, boron nitride, aluminum nitride, aluminum oxide, magnesium oxide, zinc oxide, silicon nitride, silicon carbide, and the like, metal silicon particles whose surfaces are oxidized, carbon fibers whose surfaces are coated with an insulating material such as a resin, and graphite. From the viewpoint of the thermal conductivity in the plane direction and insulation, the inorganic filler is preferably a boron nitride particle, particularly a hexagonal boron nitride particle.

An average particle diameter of the inorganic filler is preferably 1 µm to 200 µm, more preferably 5 µm to 200 µm, still more preferably 5 µm to 100 µm, and particularly preferably 10 µm to 100 µm.

The average particle diameter is a median diameter (a particle diameter at which, when a powder is divided into two particles based on a certain particle diameter, particles larger than that particle diameter and particles smaller than that particle diameter are equal in amount, generally also called D50) measured by a laser diffraction method using a laser diffraction and scattering type particle diameter distribution measurement device.

### (Plate Shape)

The heat transfer layer according to the present disclosure preferably contains a plate-shaped inorganic filler. In the present disclosure, a particle being "plate-shaped" means that the particle has a flat shape, a scaly shape, or a flake shape.

An aspect ratio of the plate-shaped inorganic filler is preferably 10 to 1000. It is preferable that the aspect ratio is 10 or more, since an orientation important for enhancing thermal diffusivity is secured, and high thermal diffusivity can be obtained. An insulating thermally conductive particle having an aspect ratio of 1000 or less is preferred from the viewpoint of ease of processing, since an increase in viscosity of the composition due to an increase in specific surface area can be prevented.

The aspect ratio is a value obtained by dividing a major axis of a particle by a thickness of the particle, that is, major axis/thickness. When the particle is spherical, the aspect ratio is 1, and the aspect ratio increases as a degree of flatness increases.

The aspect ratio can be obtained by measuring a major axis and a thickness of a particle at a magnification of 1500 times using a scanning electron microscope and calculating the major axis/thickness.

When the heat transfer layer contains a plate-shaped inorganic filler, the plate-shaped inorganic filler preferably accounts for 50 vol% or more of the entire inorganic filler. When the plate-shaped inorganic filler accounts for 50 vol% or more, a good thermal conductivity of the heat transfer layer in the in-plane direction can be ensured. A proportion of the plate-shaped inorganic filler to the entire inorganic filler is more preferably 60 vol% or more, still more preferably 70 vol% or more, even more preferably 80 vol% or more, particularly preferably 90 vol% or more, and most preferably, the inorganic filler is made of the plate-shaped inorganic filler.

### (Hexagonal Boron Nitride Particle)

Examples of the plate-shaped inorganic filler include a hexagonal boron nitride particle.

An average particle diameter of the hexagonal boron nitride particles is, for example, 1 µm or more, preferably 1 µm to 200 µm, more preferably 5 µm to 200 µm, still more preferably 5 µm to 100 µm, and particularly preferably 10 µm to 100 µm. It is preferable that the average particle diameter is 1 µm or more, since a specific surface area of the hexagonal boron nitride particle is small, and the compatibility with the resin is secured. It is preferable that the average particle diameter is 200 µm or less, since the uniformity of the thickness of the heat transfer layer can be secured at the time of forming the heat transfer layer. As the hexagonal boron nitride particle, a boron nitride particle having a single average particle diameter may be used, or a plurality of types of hexagonal boron nitride particles having different average particle diameters may be mixed and used. An aspect ratio of the hexagonal boron nitride particle is preferably 10 to 1000.

When the hexagonal boron nitride particle is used as the inorganic filler, an inorganic filler other than the boron nitride particle may be used in combination. Even in this case, the hexagonal boron nitride particle preferably accounts for 50 vol% or more of the entire inorganic filler. It is preferable that the hexagonal boron nitride particle accounts for 50 vol% or more, since a good thermal conductivity in the in-plane direction in the heat transfer layer can be secured. A proportion of the hexagonal boron nitride particle to the entire inorganic filler is more preferably 60 vol% or more, still more preferably 70 vol% or more, even more preferably 80 vol% or more, and particularly preferably 90 vol% or more, or 95 vol% or more.

It is preferable that the hexagonal boron nitride particle and the inorganic filler having an isotropic thermal conductivity are used in combination as the inorganic filler, since a balance between the thermal conductivity of the heat transfer layer in the thickness direction and the thermal conductivity of the heat transfer layer in the in-plane direction can be adjusted as necessary.

### (Orientation)

From the viewpoint of obtaining particularly high heat dissipation in the thickness direction of the laminate, the plate-shaped inorganic filler is preferably substantially perpendicular to the in-plane direction of the laminate. Therefore, it is desirable that the plate-shaped inorganic filler is oriented in the in-plane direction of the heat transfer layer.

Here, in the invention, the expression "the inorganic filler is substantially perpendicular to the in-plane direction of the laminate" means that an angle between a major plate plane of the plate-shaped inorganic filler and a major plane of the laminate is 45° to 135°, and the angle is preferably 55° to 125°, 65° to 115°, 75° to 105°, 85° to 95°, 87° to 93°, or 89° to 91°.

Whether the plate-shaped inorganic filler contained in the heat transfer layer is substantially perpendicular to the in-plane direction of the laminate can be determined by measuring and comparing an angle of a major axis of a particle and an angle of a laminate surface at a magnification of 100 times to 3000 times using a scanning electron microscope for a cross section perpendicular to the in-plane direction of the laminate.

### <Binder Resin>

The binder resin is not particularly limited. Examples of the binder resin include thermoplastic resins to be described later such as an aramid resin (aromatic polyamide), and thermosetting resins such as a silicone resin, a polyimide resin, a phenol resin, and an epoxy resin, and these resins can be used alone or in combination. The binder resin is particularly preferably an aromatic polyamide. Since an aromatic polyamide has excellent strength as compared with an aliphatic polyamide, when the aromatic polyamide is used as the binder resin, a heat transfer layer having particularly excellent retention of the inorganic filler and stability of the layer shape can be provided.

### (Thermal Characteristics)

From the viewpoint of thermal characteristics of the heat transfer layer, the binder resin preferably has excellent properties in terms of heat resistance and/or flame retardancy. In particular, a melting point or a thermal decomposition temperature of the binder resin is preferably 150°C or higher.

A melting point of the binder resin can be measured by a differential scanning calorimeter. The melting point of the binder resin is more preferably 200°C or higher, still more preferably 250°C or higher, and particularly preferably 300°C or higher. A lower limit of the melting point of the binder resin is not particularly limited, and is, for example, 600°C or lower, 500°C or lower, or 400°C or lower.

A thermal decomposition temperature of the binder is measured by a differential scanning calorimeter. The thermal decomposition temperature of the binder resin is more preferably 200°C or higher, still more preferably 300°C or higher, particularly preferably 400°C or higher, and most preferably 500°C or higher. A lower limit of the thermal decomposition temperature of the binder resin is not particularly limited, and is, for example, 1000°C or lower, 900°C or lower, or 800°C or lower.

When used as a laminate inside an electronic device for in-vehicle use, the resin material also needs to be able to withstand a high heat temperature. In the case of a power semiconductor using silicon carbide, heat resistance at about 200°C is required. Therefore, the resin having heat resistance of 200°C or higher can be suitably used for in-vehicle applications and circuit board applications around power semiconductors. Examples of such a resin include an aramid resin.

### (Thermoplastic Resin)

It is particularly preferable that the binder resin contains a thermoplastic resin, since it is considered that voids in the heat transfer layer can be further reduced. Although not intended to be limited by theory, in a case where a thermoplastic resin is used as the binder resin, it is considered that, for example, by performing a heat treatment during a pressing treatment at the time of forming the heat transfer layer, the thermoplastic resin is softened, discharge of bubbles trapped between the inorganic fillers is further promoted, and as a result, the effect of reducing voids can be further enhanced.

Examples of the thermoplastic resin that can be used as the binder resin include aramid resin, polyvinylidene fluoride (PVDF), thermoplastic polyimide resin, polytetrafluoroethylene (PTFE) resin, liquid crystal polymer (LCP) resin, polyarylate (PAR) resin, polyetherimide (PEI) resin, polyethersulfone (PES) resin, polyamideimide (PAI) resin, polyphenylene sulfide (PPS) resin, polyetheretherketone (PEEK) resin, and polybenzoxazole (PBO).

### (Aramid Resin)

In particular, the binder resin preferably contains an aramid resin (an aromatic polyamide) or is made of an aramid resin. When the binder resin contains an aramid resin, a content of the aramid resin in the binder resin is preferably 90 vol% or more. When the aramid resin is used as the binder resin, a heat transfer layer having more excellent mechanical strength is obtained while being filled with the inorganic filler at a high proportion. From the viewpoint of thermal characteristics, the binder resin preferably contains an aramid resin or is made of an aramid resin. The aramid resin has a relatively high thermal decomposition temperature, and the heat transfer layer using the aramid resin as the binder resin exhibits excellent flame retardancy.

The aramid resin is a linear polymer compound in which 60% or more of amide bonds are directly bonded to an aromatic ring. As the aramid resin, for example, polymetaphenylene isophthalamide and a copolymer thereof, and polyparaphenylene terephthalamide and a copolymer thereof can be used, and examples thereof include copolyparaphenylene-3,4'-diphenylether terephthalamide (also known as copolyparaphenylene-3,4'-oxydiphenylene terephthalamide). The aramid resin may be used alone or in combination of two or more kinds thereof.

### (Additive)

The heat transfer layer of the invention may contain a flame retardant, an anti-discoloration agent, a surfactant, a coupling agent, a colorant, a viscosity modifier, and/or a reinforcing material. Further, in order to increase the strength of the sheet, a fibrous reinforcing material may be contained. It is preferable to use short fibers of aramid resin as the fibrous reinforcing material, since addition of the reinforcing material does not reduce the heat resistance of the heat transfer layer. The fibrous reinforcing material is preferably added in a range of 0.5 parts by volume to 25 parts by volume, and more preferably added in a range of 1 part by volume to 20 parts by volume, with respect to 100 parts by volume of the heat transfer layer.

### <<Support Layer>>

As a material for the support layer according to the present disclosure, an insulating substance capable of bonding the heat transfer layer and the heat transfer layer adjacent to each other can be used. For example, a thermoplastic resin, a thermoplastic elastomer, or a cross-linkable resin can be used.

Examples of the thermoplastic resin include vinyl acetate resin, polyvinyl acetal, ethylene vinyl acetate resin, vinyl chloride resin, acrylic resin, polyamide, cellulose, and α-olefin.

Examples of the thermoplastic elastomer include chloroprene rubber, nitrile rubber, styrene-butadiene rubber, polysulfide, butyl rubber, silicone rubber, acrylic rubber, urethane rubber, silylated urethane resin, and telechelic polyacrylate.

Examples of the cross-linkable resin include an epoxy resin, a phenol resin, and a urethane resin. In particular, an epoxy resin is preferred from the viewpoint of heat resistance and adhesiveness of the heat transfer layer.

From the viewpoint of obtaining high heat resistance of the insulating layer and good adhesiveness to the adhesive layer, when the support layer is made of a thermoplastic resin, the support layer is preferably made of vinyl acetate, polyvinyl acetal, ethylene vinyl acetate resin, vinyl chloride resin, acrylic resin, polyamide, or cellulose, and more preferably made of acrylic resin, polyamide, or cellulose. When the support layer is made of a thermoplastic elastomer, the support layer is preferably made of chloroprene rubber, nitrile rubber, styrene butadiene rubber, polysulfide, butyl rubber, acrylic rubber, urethane rubber, silylated urethane resin, or telechelic polyacrylate, and more preferably made of chloroprene rubber, nitrile rubber, styrene butadiene rubber, butyl rubber, acrylic rubber, or telechelic polyacrylate. When the support layer is made of a cross-linkable resin, the support layer is preferably made of an epoxy resin, a phenol resin, or a urethane resin, more preferably made of an epoxy resin or a phenol resin, and still more preferably made of an epoxy resin.

The support layer is particularly preferably made of an acrylic resin or an epoxy resin.

When the support layer is as described above, high heat resistance of the insulating layer can be obtained due to the material forming the support layer having a high glass transition temperature and/or a high deflection temperature under load. When the support layer is as described above, surface free energy of a portion of the surface of the insulating layer where the support layer is exposed can be increased due to high surface free energy of the material forming the support layer, and thus good adhesiveness to the adhesive layer can be obtained.

The support layer may contain an additive such as a curing accelerator, an anti-discoloration agent, a surfactant, a coupling agent, a colorant, a viscosity modifier, and a filler, as long as the insulation and the adhesiveness are not impaired.

A range of a modulus of the support layer is preferably 10 MPa or more, 20 MPa or more, 30 MPa or more, 40 MPa or more, 50 MPa or more, 70 MPa or more, 100 MPa or more, 200 MPa or more, 300 MPa or more, or 400 MPa or more, and 50 GPa or less, 40 GPa or less, 30 GPa or less, 20 GPa or less, 10 GPa or less, 7 GPa or less, 5 GPa or less, 4 GPa or less, 3 GPa or less, 2 GPa or less, or 1 GPa or less. When the modulus of the support layer is within the range, there is an advantage that the insulating layer can be provided with a stiffness suitable for handling, and handleability during the production of the laminate can be improved. When the modulus of the support layer is within the range, there is an advantage that a frequency of occurrence of defects such as buckling of the insulating layer during pressure application can be reduced when pressure is applied in the metal layer forming step. When the modulus of the support layer is within the range, there is an advantage that stress generated between the layers of the laminate when the temperature of the laminate changes can be relaxed, and cracking of the insulating layer or the adhesive layer and peeling of the metal layer during use of the laminate can be prevented.

The modulus of the support layer can be determined based on a tensile stress-strain curve of the support layer.

### <<Metal Layer A and Metal Layer B>>

Materials for the metal layer A and the metal layer B according to the present disclosure are not particularly limited. Examples of types of the metal include pure metals such as titanium, aluminum, beryllium, magnesium, iron, lead, gold, platinum, silver, copper, chromium, cadmium, zinc, arsenic, manganese, cobalt, nickel, molybdenum, tungsten, tin, and bismuth, and alloys containing these metals. Non-metallic elements such as carbon and oxygen may be contained as impurities and additives. In particular, from the viewpoint of heat dissipation and cost, a pure metal such as copper or aluminum and an alloy containing copper or aluminum are desirable. The metal layer A and the metal layer B may be made of the same material, or may be made of different materials depending on the intended use.

The metal layer A and the metal layer B may have a uniform surface shape, or may have a pattern shape such as a circuit, a dot shape, or a line shape.

Thicknesses of the metal layer A and the metal layer B are not particularly limited. When the thickness of the metal layer is small, there are advantages that thermal resistance in a thickness direction is small, patterning of the metal layer is easy, the weight of the laminate is smaller, and the production cost of the laminate is low. On the other hand, when the thickness of the metal layer is large, there are advantages that thermal diffusivity of the laminate in the in-plane direction is high, and rigidity of the laminate can be secured even when a flexible insulating layer is used. The thicknesses of the metal layer A and the metal layer B may be the same as or may be different thicknesses depending on the application.

### <<Adhesive Layer>>

As a material for the adhesive layer that can be provided in the present disclosure, an insulating substance capable of adhering the insulating layer and the metal layer can be used. For example, a thermoplastic resin, a thermoplastic elastomer, or a cross-linkable resin can be used.

Examples of the thermoplastic resin include vinyl acetate resin, polyvinyl acetal, ethylene vinyl acetate resin, vinyl chloride resin, acrylic resin, polyamide, cellulose, and α-olefin.

Examples of the thermoplastic elastomer include chloroprene rubber, nitrile rubber, styrene-butadiene rubber, polysulfide, butyl rubber, silicone rubber, acrylic rubber, urethane rubber, silylated urethane resin, and telechelic polyacrylate.

Examples of the cross-linkable resin include an epoxy resin, a phenol resin, and a urethane resin. In particular, an epoxy resin is preferred from the viewpoint of heat resistance and adhesiveness to the insulating layer and the metal layer.

From the viewpoint of obtaining high heat resistance of the adhesive layer and good adhesiveness to the insulating layer and/or the metal layer, when the adhesive layer is made of a thermoplastic resin, the adhesive layer is preferably made of vinyl acetate, polyvinyl acetal, an ethylene vinyl acetate resin, a vinyl chloride resin, an acrylic resin, polyamide, or cellulose, and more preferably made of an acrylic resin, polyamide, or cellulose. When the adhesive layer is made of a thermoplastic elastomer, the adhesive layer is preferably made of chloroprene rubber, nitrile rubber, styrene butadiene rubber, polysulfide, butyl rubber, acrylic rubber, urethane rubber, silylated urethane resin, or telechelic polyacrylate, and more preferably made of chloroprene rubber, nitrile rubber, styrene butadiene rubber, butyl rubber, acrylic rubber, or telechelic polyacrylate. When the adhesive layer is made of a cross-linkable resin, the adhesive layer is preferably made of an epoxy resin, a phenol resin, or a urethane resin, more preferably made of an epoxy resin or a phenol resin, and still more preferably made of an epoxy resin.

The adhesive layer is particularly preferably made of an acrylic resin or an epoxy resin, and most preferably made of an epoxy resin.

When the adhesive layer is as described above, high heat resistance of the adhesive layer can be obtained due to the material forming the adhesive layer having a high glass transition temperature and/or a high deflection temperature under load. When the adhesive layer is as described above, surface free energy of the adhesive layer can be increased, so that good adhesiveness to the insulating layer and/or metal layer can be obtained.

The adhesive layer may contain an additive such as a curing accelerator, an anti-discoloration agent, a surfactant, a coupling agent, a colorant, a viscosity modifier, and a filler, as long as the insulation and the adhesiveness are not impaired. In particular, addition of a thermally conductive ceramic particle is a preferred aspect since a thermal resistance value of a circuit board in a thickness direction can be further reduced.

The tensile shear adhesive strength between the insulating layer and the metal layer can be set to a value larger than shear stress assumed to occur between the insulating layer and the adhesive layer and between the metal layer and the insulating layer in order to reduce a frequency of defects (peel defects) that occur when peeling occurs between the insulating layer and the adhesive layer and between the metal layer and the insulating layer. Examples of such stress include, but are not limited to, stress in a shear direction that is applied between the insulating layer and the metal layer in a state where the laminate is used, and stress between the insulating layer and the adhesive layer and between the metal layer and the insulating layer, which occurs due to a difference in linear expansion amount between the insulating layer and the metal layer that is caused by a temperature change.

The tensile shear adhesive strength between the insulating layer and the metal layer is preferably 0.1 MPa or more, 0.2 MPa or more, 0.3 MPa or more, 0.4 MPa or more, 0.5 MPa or more, 0.7 MPa or more, 1 MPa or more, 2 MPa or more, 3 MPa or more, 4 MPa or more, or 5 MPa or more, and 1000 MPa or less, 700 MPa or less, 500 MPa or less, 400 MPa or less, 300 MPa or less, 200 MPa or less, 100 MPa or less, 70 MPa or less, 50 MPa or less, 40 MPa or less, 30 MPa or less, or 20 MPa or less. The tensile shear adhesive strength is more preferably 2 MPa or more, still more preferably 3 MPa or more, and particularly preferably 4 MPa or more. When the tensile shear adhesive strength between the insulating layer and the metal layer is within the range, there is an advantage that a frequency of peeling defects between the insulating layer and the adhesive layer and between the metal layer and the insulating layer can be reduced.

The tensile shear adhesive strength between the insulating layer and the metal layer can be determined by a tensile test of the laminate.

The laminate of the invention is excellent in heat dissipation in the thickness direction, thermal diffusivity in the in-plane direction, and insulation in the thickness direction, and is not easily cracked. Therefore, the laminate can be used as a circuit board by processing the metal layer to form a predetermined conductor circuit.

### [Method for Producing Laminate]

The present disclosure includes the following method for producing a laminate according to the present disclosure:
a step of preparing a heat transfer layer using a slurry containing a plate-shaped inorganic filler, a binder resin, and a solvent; a step of preparing an insulating layer by alternately laminating the heat transfer layer and a support layer and then performing cutting; and a step of forming a metal layer by bonding metal layers to respective surfaces of the insulating layer.

### <<Step of Preparing Heat Transfer Layer>>

The step of preparing a heat transfer layer includes a mixing step of mixing at least a plate-shaped inorganic filler, a binder resin, and a solvent to obtain a slurry, a molding step of molding the slurry after the mixing step into a sheet shape and drying the slurry to form a heat transfer layer precursor, and a pressing step of compressing the heat transfer layer precursor.

### <Mixing Step>

In the mixing step in the step of preparing a heat transfer layer in the production method according to the present disclosure, a plate-shaped inorganic filler, a binder resin, and a solvent are mixed to obtain a slurry.

For the inorganic filler and the binder resin, the contents described above for the heat transfer layer can be referred to.

In the mixing step, an additive such as a flame retardant, an anti-discoloration agent, a surfactant, a coupling agent, a colorant, a viscosity modifier, and/or a reinforcing material may be added freely. In order to increase strength of the sheet, a fibrous reinforcing material may be added.

In the mixing step, anhydrous calcium chloride or anhydrous lithium chloride may be added. By adding anhydrous calcium chloride or anhydrous lithium chloride in the mixing step, solubility of the binder resin in the solvent may be improved. In particular, when an aramid resin is used as the binder resin, anhydrous calcium chloride or anhydrous lithium chloride is preferably added in the mixing step, and in this case, solubility of the aramid resin in the solvent can be further improved.

### (Solvent)

As the solvent, a solvent capable of dissolving the binder resin can be used. For example, when an aramid resin is used as the binder resin, 1-methyl-2-pyrrolidone (NMP), N, N-dimethylacetamide, or dimethyl sulfoxide can be used.

### (Mixing)

To mix the insulating particles, the binder resin, and the solvent, a general kneading device such as a paint shaker, a bead mill, a planetary mixer, an agitation disperser, a self-rotating agitation mixer, a three-roll mill, a kneader, or a single-screw or twin-screw kneader can be used.

### <Molding Step>

In the molding step in the step of preparing a heat transfer layer in the production method according to the present disclosure, the slurry after the mixing step is molded into a sheet shape and dried to form a heat transfer layer precursor.

### (Molding)

In order to mold the slurry after the mixing step into a sheet shape, a known method such as a method of applying the slurry onto a release film with a coater can be used.

### (Drying)

The drying may be performed by a known method. For example, the slurry applied on the substrate may be dried, and then the molded slurry may be peeled off from the substrate in water, followed by further drying. A drying temperature may be, for example, 50°C to 300°C, and a drying time may be, for example, 30 seconds to 3 hours.

In the molding step, a water washing treatment may be performed. By performing the water washing treatment, the residual solvent and, if present, the salt in the heat transfer layer can be reduced. The water washing treatment may be performed, for example, by drying the slurry applied and molded on the substrate and then immersing the slurry in ion-exchanged water or distilled water for 10 minutes to 3 hours. The water washing treatment may be performed on the heat transfer layer precursor. When anhydrous calcium chloride or anhydrous lithium chloride is added in the mixing step, the water washing treatment is preferably performed.

It is considered that since the molded slurry or the heat transfer layer precursor has more voids than the heat transfer layer subjected to a compression treatment, permeability of water is high. Therefore, it is considered that the residual solvent and the salt can be more efficiently removed by performing the water washing treatment before performing the compression treatment.

Water contained in the heat transfer layer can be reduced by drying after washing with water or by the compression treatment.

### <Compression Step>

In the compression step in the step of preparing a heat transfer layer in the production method according to the present disclosure, the heat transfer layer precursor is compressed.

As described above, a heat transfer layer having an excellent thermal conductivity in the in-plane direction can be obtained by compressing the heat transfer layer precursor.

When the heat transfer layer precursor is compressed, a heat transfer layer having a surface structure with relatively high smoothness can be obtained.

In the compression step, a general press device such as a vertical flat press or a roll press can be used. The roll press is preferred since air contained in the heat transfer layer precursor is easily discharged to increase the density and increase the thermal conductivity. The atmosphere of the press device may be atmospheric pressure or vacuum.

### (Roll Press)

The roll press may be performed by a known method, and for example, a calender roll machine may be used to perform a pressure treatment on the heat transfer layer precursor. Pressure applied to the heat transfer layer precursor in the roll press step is preferably 400 N/cm to 8000 N/cm in linear pressure. When the linear pressure is 400 N/cm or more, discharge of air bubbles outside the heat transfer layer becomes noticeable. When the linear pressure is 8000 N/cm or less, the inorganic filler is densely filled so as not to be broken, and the voids in the heat transfer layer can be reduced. A diameter of a roll to be used in the roll press is preferably, for example, 200 mm to 1500 mm.

In the compression step, the heat transfer layer precursor is preferably heated. A heating temperature can be appropriately set according to the type of the binder resin to be used. When an aramid resin is used as the binder resin, the heating temperature is preferably 100°C to 350°C. By setting the heating temperature to 100°C or higher, the binder resin is easily softened, and the effect of filling a gap between the inorganic fillers by the compression treatment is easily obtained. When the heating temperature is 350°C or lower, the strength of the binder resin is less likely to decrease due to a thermal history.

### <<Step of Preparing Insulating Layer>>

The step of preparing an insulating layer includes a lamination step of alternately laminating the heat transfer layer and the support layer, and a cutting step of cutting the laminated heat transfer layer/support layer in a thickness direction of the lamination.

### <Lamination Step>

The lamination step may be performed by alternately laminating a plurality of heat transfer layers and support layers in the thickness direction, and for example, a laminate may be obtained by laminating a heat transfer layer and a support layer that are cut into an appropriate size.

The lamination step may be performed by folding or winding the heat transfer layer and the support layer, and for example, an alternately laminate of the heat transfer layer/support layer may be obtained by repeating a process of forming a first layer by winding a heat transfer layer around a core material or a plate material in a state where a support layer is applied to one surface of the heat transfer layer, and further forming a second layer by winding a new layer thereon until a desired number of layers is obtained. The heat transfer layer and the support layer unwound from another shaft may be simultaneously folded or wound to obtain an alternate laminate of the heat transfer layer/support layer. A liquid or powdery support layer may be applied every time one heat transfer layer is laminated.

A plurality of laminates obtained by these methods may be prepared and laminated to prepare a laminate.

In the lamination step, a heat treatment may be further performed after laminating the heat transfer layer/support layer. When the support layer is made of a thermoplastic resin, adhesion between the layers in the obtained laminate is further improved by further performing a heat treatment. When the support layer is made of a thermosetting resin, adhesive strength between the layers is improved. A temperature during the heat treatment may be appropriately set according to the binder resin contained in the heat transfer layer, the type of the support layer, and the like.

As the support layer to be used in the lamination step, for example, a molecular gradient membrane double-sided tape "200Y" (manufactured by KGK Chemical Corporation) can be used. When 200Y is used as the support layer, in order to improve the adhesion between the support layer and the heat transfer layer, the heat treatment can be performed after laminating the heat transfer layer/support layer in the lamination step. Patent Literature 5 (JP2006-232896A) discloses that peel strength is improved at a heating temperature of 150°C or higher and 200°C or lower, and when the heat treatment is performed after the heat transfer layer/support layer is laminated, for example, the adhesion can be improved by maintaining the heat treatment under such conditions.

As the support layer to be used in the lamination step, for example, a heat dissipation insulating adhesive sheet "EAL" (manufactured by Arisawa Manufacturing Co., Ltd.) can be used. When EAL is used as the support layer, in order to improve the adhesion between the support layer and the heat transfer layer, the heat treatment can be performed after laminating the heat transfer layer/support layer in the lamination step. In the catalog (https://www.arisawa.co.jp/jp/products/data/CATALOG_EA_JP. PDF) for a heat dissipation insulating adhesive sheet "EA series", heat treatment conditions disclosed are 180°C, 60 minutes, and 3 MPa to 20 MPa, and when the heat treatment is performed after laminating the heat transfer layer/support layer, for example, the adhesion can be improved by maintaining the heat treatment under such conditions.

### <Cutting Step>

In the cutting step, the laminate is cut substantially along a lamination direction of the heat transfer layer/support layer to obtain an insulating layer.

The cutting treatment is performed such that a thickness direction of the insulating layer obtained by the cutting and the lamination direction of the heat transfer layer forming the insulating layer are substantially perpendicular to each other.

The cutting treatment may be performed by a known method, for example, a multi-blade method, a laser processing method, a water jet method, or a knife processing method. The cutting treatment can be performed using, for example, a general cutting tool or cutting machine such as a cutter knife, a razor, or a Thomson blade provided with a sharp blade. By using a cutting tool provided with a sharp blade or the like, disturbance of the particle orientation in the vicinity of the surface of the heat dissipation sheet obtained after the cutting treatment can be prevented and an insulating layer having a relatively thin thickness can be easily obtained.

A thickness of the insulating layer obtained by the cutting treatment is not particularly limited, and is, for example, 0.02 mm to 5 mm, and preferably 0.1 mm to 1 mm. When the thickness of the insulating layer is within the range, a laminate having low thermal resistance in the thickness direction, excellent heat dissipation in the thickness direction, and high insulation between the metal layer A and the metal layer B can be provided.

### <<Step of Forming Metal Layer>>

The step of forming a metal layer can be performed by any method capable of laminating and fixing the metal layer A, the adhesive layer, the insulating layer, the adhesive layer, and the metal layer B in this order.

When a raw material for the adhesive layer is liquid, the metal layer A, the metal layer B, or the insulating layer can be applied with a coater.

The step of laminating a metal layer may include a heating step of laminating the metal layer A, the adhesive layer, the insulating layer, the adhesive layer, and the metal layer B in this order and then performing heating to strengthen the adhesion between the layers.

When the adhesive layer is made of a thermoplastic resin or a thermoplastic elastomer, there is an advantage that the thermoplastic resin melts and the thermoplastic resin adheres to the metal layer and the insulating layer, thereby strengthening the adhesion between the layers. When the adhesive layer is made of a curable resin, there is an advantage that crosslinking of the resin is promoted by heating and adhesion between the layers can be strengthened.

When a cross-linkable resin is used as the adhesive layer, after laminating the metal layer A, the adhesive layer, the insulating layer, the adhesive layer, and the metal layer B in this order, the resin forming the adhesive layer can be crosslinked by any method for crosslinking the adhesive layer. By using any method of crosslinking the adhesive layer, there is an advantage that adhesion between the layers can be strengthened.

As any method of crosslinking the adhesive layer, light irradiation, radiation irradiation, or the like can be used, but the method is not limited thereto.

The step of forming a metal layer can include a step of applying pressure to the laminate including the metal layer A, the adhesive layer, the insulating layer, the adhesive layer, and the metal layer B using a press device. The atmosphere of the press device may be atmospheric pressure or vacuum.

### [Examples]

Hereinafter, the invention according to the disclosure will be specifically described with reference to Examples.

### <<Examples 1 to 7, and Comparative Examples 1 to 3>>

Heat transfer layers, insulating layers, metal layers, and laminates according to Examples 1 to 7, and laminates according to Comparative Examples 1 to 3 were prepared. Characteristics of the obtained heat transfer layers, insulating layers, metal layers, and laminates were measured. The measurement was performed by the following method.

### (1) Thermal Conductivities in In-plane Direction and Thickness Direction

Thermal conductivities of the heat transfer layer and the insulating layer were calculated by multiplying thermal diffusivity, a specific gravity, and specific heat in a thickness direction and in an in-plane direction, respectively.
(Thermal conductivity) = (thermal diffusivity) × (specific heat) × (specific gravity)

The thermal diffusivity in the thickness direction was determined by a temperature wave analysis method. As a measurement device, ai-Phase mobile M3 type1 manufactured by ai-Phase Co., Ltd. was used. The thermal diffusivity in the in-plane direction was determined by a periodic heating radiation temperature measurement method. As a measurement device, TA-33 manufactured by BETHEL Co., Ltd. was used. The specific heat was determined using a differential scanning calorimeter (DSCQ10 manufactured by TA Instruments). The specific gravity was determined based on an outer dimension and a weight of an insulating sheet.

### (2) Dielectric Breakdown Voltage

A dielectric breakdown voltage of the insulating layer was measured in accordance with the test standard ASTM D149-20. As a measurement device, a dielectric strength test device manufactured by Tokyo Transformer Co., Ltd. was used. The measurement was performed in insulating oil in order to avoid creeping discharge at the end of the insulating layer.

### (3) Thermal Resistance in Thickness Direction

For thermal resistance of the laminate in the thickness direction, a 40 mm × 40 mm test piece and a steady-state thermal conductivity measuring device SS-H40 manufactured by BETHEL Co., Ltd. were used. The thermal resistance was measured at an upper heater temperature of 70°C, a lower cooling water temperature of 23°C, and a pressing force of 1200 N. A small amount of an oil compound (G-746 manufactured by Shin-Etsu Chemical Co., Ltd.) was uniformly applied to an interface between each metal layer of the laminate and a device-side contact portion (copper cartridge). The obtained thermal resistance value between the copper cartridges was multiplied by 16 to obtain a converted value of the thermal resistance per 1 cm square.

### (4) Orientation of Inorganic Filler

Presence or absence of the inorganic filler in the insulating layer inside the laminate and orientation of the inorganic filler were confirmed by exposing a cross section of the laminate with a general cutter and then observing the cross section at a magnification of 250 times with a scanning electron microscope (TM4000 manufactured by Hitachi High-Technologies Corporation).

### (5) Permittivity and Dielectric Loss Tangent of Insulating Layer

A real part (a relative permittivity) of a complex permittivity and a dielectric loss tangent of the insulating layer were measured by a parallel plate method. When an object to be measured was regarded as an equivalent circuit in which a capacitor and a resistor were connected in parallel, capacitance of the capacitor and conductance of the resistor were measured using a semiconductor parameter analyzer (Keythley 4200-SCS, manufactured by Keithley Instruments). The measurement was performed by applying a sine wave of 100 mV at frequencies of 1 kHz and 1 MHz. The real part (the relative permittivity) of the complex permittivity and the dielectric loss tangent were obtained by the following formulae.
(Real part (relative permittivity) of complex permittivity) = [(capacitance) × (distance between parallel plates)]/[(permittivity of vacuum) × (parallel plate area)]] (Dielectric loss tangent) = [(conductance) × (real part (relative permittivity) of complex permittivity]/[(frequency) × (capacitance)]

### (6) Modulus of Support Layer

A modulus of the support layer was measured using a tensile tester (TENSILON RTC-1210 manufactured by A&D Company, Limited). The modulus of the support layer was determined by gripping the support layer for modulus measurement with a tensile tester at a chuck-to-chuck distance of 50 mm, acquiring a tensile stress-strain curve from a strain of 0 to a strain at a breaking point when a tensile displacement was applied under a condition of 1 mm/min, calculating a gradient of the curve between a point where the strain was 0.0005 and a point where the strain was 0.0025 using a least square method, and dividing the gradient by a cross-sectional area. When the strain at the breaking point was 0.0025 or less, a gradient of a curve between a point where a strain was obtained by multiplying the strain at the breaking point by 0.2 and a point where a strain was obtained by multiplying the strain at the breaking point by 0.8 was calculated by the least squares method, and the modulus was obtained by dividing the gradient by the cross-sectional area.

### (7) Tensile Shear Adhesive Strength Between Insulating Layer and Metal Layer

Tensile shear adhesive strength between the insulating layer and the metal layer was measured using a tensile tester (TENSILON RTC-1210 manufactured by A&D Company, Limited). Each of two copper plates of the laminate for tensile shear adhesive strength measurement was held by a tensile tester, and a tensile stress-strain curve was obtained from a strain of 0 to a strain at the breaking point when a tensile displacement was applied under a condition of 1 mm/min, and the tensile shear adhesive strength was obtained by dividing stress at the breaking point by an adhesive area. The adhesion area is an area of a main surface of the insulating layer of the laminate for the tensile shear adhesive strength measurement.

### <<Example 1>>

### <Production of Heat Transfer Layer>

In a state where 9.3 parts by mass of para-aramid resin "Technora" (manufactured by TEIJIN LIMITED) as a binder resin and 8.1 parts by mass of calcium chloride (manufactured by Fujifilm Wako Pure Chemical Industries, Ltd.) were dissolved in 363 parts by mass of 1-methyl-2-pyrrolidone, 90.7 parts by mass of plate-shaped hexagonal boron nitride particles "HSPD" (manufactured by Dandong Chemical Engineering Institute Co., average particle diameter 45 µm, aspect ratio 35) were added, and the mixture was mixed by stirring for 120 minutes with a planetary mixer while heating to 80°C to obtain a uniform slurry.

The obtained slurry was applied onto a PET film using a slit die coater, molded into a sheet shape, and dried at 120°C for 20 minutes on average. Thereafter, the molded slurry was peeled off from the PET film, then immersed in water for 5 minutes, and dried at 150°C for 2 minutes to obtain a heat transfer layer precursor having a thickness of 150 µm. The obtained heat transfer layer precursor was subjected to a compression treatment by a calender roll machine under conditions of a temperature of 220°C and a linear pressure of 640 kgf/cm (6270 N/cm) to obtain a heat transfer layer having a thickness of 42 µm. A thermal conductivity of the heat transfer layer in an in-plane direction was 42 W/(m•K).

### <Production of Insulating Layer>

The obtained heat transfer layer and a die bonding film "HS-260" (manufactured by Resonac Holdings Corporation (formerly Showa Denko Materials Inc.), cross-linkable resin (epoxy type), thickness 10 µm) as a support layer were alternately laminated to form 1000 layers, and pressed using a vacuum hot press at a temperature of 130°C, a pressure of 3 MPa, and a vacuum degree of 0.5 Pa for 2 hours to obtain an insulating layer precursor. The obtained insulating layer precursor was cut twice at intervals of 0.2 mm with a razor blade substantially perpendicular to the main surface of the heat transfer layer to obtain an insulating layer having a thickness of 0.2 mm. A thermal conductivity of the insulating layer in the thickness direction was 34 W/mK, and a thermal conductivity of the insulating layer in the in-plane direction was 23 W/(m•K).

### <Formation of Metal Layer (Preparation of Laminate)>

One of main surfaces of the obtained insulating layer was entirely coated with room temperature curing two-component epoxy resin "2088E" (manufactured by ThreeBond Co., Ltd.) to a thickness of approximately 1 µm to 5 µm, and a copper foil of a thickness of 10 µm was bonded thereon, followed by heating in air at 120°C for 90 minutes while being pressed with a Bahco type clamp. Similarly, a copper foil of 10 µm was formed on the other one of the main surfaces of the insulating layer to obtain a laminate for cross-sectional observation in which copper foils were formed on both surfaces of the insulating layer. Similarly, copper plates having a thickness of 1 mm were bonded to both surfaces of the insulating layer to prepare a laminate for thermal resistance measurement. In the laminate thus obtained, a thickness of the support layer in the lamination direction between the support layer and the heat transfer layer was 10.6 µm. In the insulating layer, a thickness of the heat transfer layer in the lamination direction between the heat transfer layer and the support layer was 3.96 times the thickness of the support layer in the lamination direction.

### <Measurement of Modulus of Support Layer>

The die-bonding film "HS-260" (manufactured by Resonac Holdings Corporation (formerly Showa Denko Materials Inc.), thickness 10 µm) used for forming the support layer was heated at a temperature of 130°C for 2 hours, and then cut into a width of 10 mm and a length of 100 mm to obtain a film for modulus measurement. The modulus was 425 MPa.

### <Measurement of Tensile Shear Adhesive Strength>

In the laminate thus obtained, tensile shear adhesive strength between the insulating layer and the metal layer was 7.3 MPa.

### <<Example 2>>

A laminate for thermal resistance measurement was prepared in the same manner as in Example 1 except that a bonding sheet "A11F" (manufactured by Arisawa Manufacturing Co., Ltd.) was used as a support layer, and pressing was performed for 1 hour under conditions of a temperature of 160°C, a pressing force of 3 MPa, and a degree of vacuum of 0.5 Pa in formation of an insulating layer precursor in a production step of an insulating layer.

A thickness of a support layer of the laminate thus obtained was 14.3 µm. In the insulating layer, a thickness of a heat transfer layer in a lamination direction between the heat transfer layer and the support layer was 2.94 times the thickness of the support layer in the lamination direction.

### <<Example 3>>

A laminate for thermal resistance measurement was prepared in the same manner as in Example 2 except that a thickness of an insulating layer was 0.4 mm. A thickness of a support layer and a ratio of a thickness of a heat transfer layer in a lamination direction to a thickness of the support layer in the lamination direction were the same as in Example 2.

### <<Example 4>>

A laminate for thermal resistance measurement was prepared in the same manner as in Example 2 except that a heat dissipation bonding sheet "EAL" (manufactured by Arisawa Manufacturing Co., Ltd.) was used as an adhesive layer. A thickness of a support layer and a ratio of a thickness of a heat transfer layer in a lamination direction to a thickness of the support layer in the lamination direction were the same as in Example 2.

### <<Example 5>>

A laminate for thermal resistance measurement was prepared in the same manner as in Example 2 except that a copper plate having a thickness of 1 mm was formed as the metal layer A on one surface of an insulating layer, and a copper foil having a thickness of 0.01 mm was formed as the metal layer B on one surface of the insulating layer. A thickness of a support layer and a ratio of a thickness of a heat transfer layer in a lamination direction to a thickness of the support layer in the lamination direction were the same as in Example 2.

### <<Example 6>>

A laminate for thermal resistance measurement was prepared in the same manner as in Example 5 except that a heat dissipation insulating adhesive sheet "EAL" was used as an adhesive layer, and pressing was performed under conditions of 180°C, 4 MPa, and 60 min in formation of an insulating layer precursor in a production step of an insulating layer. A thickness of a support layer and a ratio of a thickness of a heat transfer layer in a lamination direction to a thickness of the support layer in the lamination direction were the same as in Example 2.

### <<Example 7>>

A laminate for thermal resistance measurement was prepared in the same manner as in Example 1 except that a molecular orientation film double-sided tape "200Y" was used as a support layer, and pressing was performed under conditions disclosed in Patent Literature 5 in formation of an insulating layer precursor in a production step of an insulating layer.

A thickness of a support layer of the laminate thus obtained was 17.8 µm. In the insulating layer, a thickness of a heat transfer layer in a lamination direction between the heat transfer layer and the support layer was 2.36 times the thickness of the support layer in the lamination direction.

### <<Comparative Example 1>>

A general low thermal resistance metal base substrate was prepared and evaluated. A 0.12 mm-thick insulating heat dissipation resin (epoxy resin + alumina particles + aluminum nitride particles, manufactured by RISHO KOGYO CO., LTD.) was applied as an insulating layer onto a 1 mm-thick copper plate, and a 70 µm-thick copper foil was attached to thermally cure the insulating heat dissipating resin to prepare a laminate for thermal resistance measurement.

### <<Comparative Example 2>>

A laminate for cross-sectional observation and thermal resistance measurement was prepared in the same manner as in Examples using, as an insulating layer, a 0.2 mm-thick insulating heat dissipation sheet "TC-20EG" (spherical inorganic filler + silicone resin) manufactured by Shin-Etsu Chemical Co., Ltd.

### <<Comparative Example 3>>

A laminate for cross-sectional observation and thermal resistance measurement was prepared in the same manner as in Examples using, as an insulating layer, a 0.2 mm-thick insulating heat dissipation sheet "TC-20BG" (plate-shaped inorganic filler + silicone resin) manufactured by Shin-Etsu Chemical Co., Ltd.

Preparation conditions and measurement results in Examples and Comparative Examples 1 to 3 are shown in Table 1.

**[Table 1]**

| | | | Example 1 | Example 2 | Example 3 | Example 4 | Example 5 | Example 6 | Example 7 | Comparative Example 1 | Comparative Example 2 | Comparative Example 3 |
|---|---|---|---|---|---|---|---|---|---|---|---|---|
| Configuration | Insulating layer | Heat transfer layer | Hexagonal boron nitride particles "HSPD" + aramid resin "Technora" | | | | | | | Low thermal resistance metal base substrate (alumina particles + aluminum hydroxide particles + epoxy resin) | TC-20EG (spherical inorganic filler + silicone resin) | TC-20BG (plate-shaped inorganic filler + silicone resin) |
| | | Support layer | HS-260 | A11F | | | | | 200Y | | | |
| | | Number of lamination layers | 3 or more layers | | | | | | | 1 layer | | |
| | Thickness [mm] of insulating layer | | 0.2 | | 0.4 | 0.2 | | | 0.4 | 0.12 | 0.2 | 0.2 |
| | Adhesive layer | | 2088E | | | EAL | 2088E | \| EAL | 2088E | (None) | 2088E | 2088E |
| | Metal layer | A (upper surface) | Copper plate 1 mm thick | | | | | | | Copper foil 70 µm thick | Copper plate 1 mm thick | Copper plate 1 mm thick |
| | | B (lower surface) | Copper plate 1 mm thick | | | | Copper foil 0.01 mm | | Copper plate 1 mm thick | Copper plate 1 mm thick | Copper plate 1 mm thick | Copper plate 1 mm thick |
| Orientation of plate-shaped inorganic filler | | | Thickness direction of substrate | | | | | | | Not used | Not used | In-plane direction of substrate |
| Ratio of thickness of heat transfer layer in lamination direction to thickness of support layer in lamination direction between heat transfer layer and support layer | | | 3.96 | 2.94 | 2.94 | 2.94 | 2.94 | 2.94 | 2.36 | - | - | - |
| Characteristics | Thermal conductivity [W/(m)•K] of heat transfer layer | In-plane direction | 42 | | | | | | | - | - | - |
| | | Thickness direction | 2.0 | | | | | | | - | - | - |
| | Thermal conductivity [W/(m)•K] of insulating layer | In-plane direction | 23 | | | | | | 25 | 10 | 5.8 | 12 |
| | | Thickness direction | 34 | | | | | | 30 | 10 | 3.1 | 7.3 |
| | Dielectric breakdown voltage [kV@DC] of insulating layer | | 8.7 | | | | | | 3.2 | 5.0 | 4.0 | 7.0 |
| | Thermal resistance [(K•cm²)/W] in thickness direction | | 0.32 | 0.27 | 0.22 | 0.27 | 0.22 | 0.27 | 0.31 | 0.40 | 1.28 | 1.12 |
| | Relative permittivity (1 kHz) | | 5.4 | 4.0 | | | | | 4.3 | 7.8 | 6.1 | 3.4 |
| | Dielectric loss tangent (1 kHz) | | 0.015 | 0.013 | | | | | 0.027 | 0.003 | 0.002 | 0.002 |
| | Relative permittivity (1 MHz) | | 5.0 | 3.8 | | | | | 3.8 | 8.0 | 6.2 | 3.4 |
| | Dielectric loss tangent (1 MHz) | | 0.015 | 0.019 | | | | | 0.024 | 0.014 | 0.010 | 0.005 |
| | Tensile shear adhesive strength (MPa) | | 7.3 | 11.5 | 11.5 | 3.1 | 11.5 | 3.1 | 9.2 | - | 3.4 | 7.5 |

### Industrial Applicability

The laminate of the invention can be suitably used as a laminate for mounting a semiconductor element which generates a large amount of heat or which is required to have high insulation.

### Reference Signs List

11 laminate
12 insulating layer
13 adhesive layer
14 metal layer
15 metal layer A
16 metal layer B
17 heat transfer layer
18 support layer
19 plate-shaped inorganic filler
20 binder resin

## Claims

1. A laminate comprising:
a metal layer A;
an insulating layer provided on at least one surface of the metal layer A; and
a metal layer B provided on a surface of the insulating layer opposite to the metal layer A, wherein
the insulating layer includes a support layer and a heat transfer layer containing at least an inorganic filler and a binder resin, and
the support layer and the heat transfer layer are alternately laminated in a total of three or more layers in a direction substantially perpendicular to a thickness direction of the insulating layer.

2. The laminate according to claim 1, wherein
the inorganic filler has a plate shape, and the inorganic filler is substantially perpendicular to an in-plane direction of the laminate.

3. The laminate according to claim 1 or 2, wherein
the inorganic filler contains a hexagonal boron nitride particle.

4. The laminate according to claim 1 or **2,** wherein
the binder resin contains an aramid resin.

5. The laminate according to claim 1 or **2,** wherein
tensile shear adhesive strength between the insulating layer and the metal layer A is 0.1 MPa or more.

6. The laminate according to claim 1 or 2, wherein
the support layer has a modulus of 10 MPa or more.

7. A circuit board comprising:
the laminate according to claim 1.

8. A method for producing a laminate, which is a method for producing the laminate according to claim 1 or 2, the method comprising:
a step of preparing a heat transfer layer using a slurry containing a plate-shaped inorganic filler, a binder resin, and a solvent;
a step of preparing an insulating layer by alternately laminating the heat transfer layer and a support layer and then performing cutting; and
a step of forming a metal layer by bonding metal layers A and B to respective surfaces of the insulating layer.
